# EUROPEAN PATENT APPLICATION

(11) **EP 4 498 097 A1**
(43) Date of publication of application: **29.01.2025**
(21) Application number: 24184328.3
(22) Date of filing: 25.06.2024
(51) Int. Cl.: G01R 15/20, G01R 33/07

(54) **STRUCTURE TO IMPROVE SENSOR ACCURACY**

(30) Priority: 28.07.2023 CN 202310945113
(71) Applicant: Honeywell International Inc., Charlotte, NC 28202 (US)
(72) Inventor: GAO, Jun, Charlotte, 28202 (US); YANG, Fan, Charlotte, 28202 (US); HU, Yu, Charlotte, 28202 (US); ZHOU, Zhou, Charlotte, 28202 (US); CHEN, Wu, Charlotte, 28202 (US); HUANG, Changchang, Charlotte, 28202 (US)
(74) Representative: Haseltine Lake Kempner LLP

(57) **Abstract**

A structure for reducing displacement of a magnetic sensor in an open loop magnetic core is provided. The structure can include a body having a first end and a second end. The structure can include a first elasticity component connected to the first end extending in a direction away from the body and a second elasticity component connected to the second end extending in a direction away from the body. The structure can include two clamp components connected to the body between the first and second ends, where the two clamp components are configured to secure the magnetic sensor. The structure can be compressible in response to an application of force to outer surfaces of the elasticity components.

## Description

### TECHNICAL FIELD

The present application relates generally, in some examples, to a structure. More specifically, the present application relates, in some examples, to a structure for securing a sensor.

### BACKGROUND

Sensors are often used to determine a level of current passing through an open loop magnetic core. For example, a sensor may determine the level of current by measuring a magnetic field. The inventors have identified numerous deficiencies and problems with the existing technologies in this field. For example, existing technologies may be displaced, resulting in a less accurate measurement of a magnetic field and/or an amount of current. Through applied effort, ingenuity, and innovation, many of these identified deficiencies and problems have been solved by developing solutions that are structured in accordance with the embodiments of the present disclosure, many examples of which are described in detail herein.

### BRIEF SUMMARY

In an example embodiment, a structure is provided for reducing displacement of a magnetic sensor in an open loop magnetic core. The example structure includes a body extending in a horizontal direction H and a transverse direction T orthogonal to horizontal direction H, where the body includes a first end and a second end spaced along the horizontal direction H. The example structure includes a first elasticity component connected to the first end, where the first elasticity component extends in a direction away from the body, and where the first elasticity component includes an outer surface defining the furthest point on the first elasticity component from the body along the horizontal direction H. The example structure includes a second elasticity component connected to the second end, where the second elasticity component extends in a direction away from the body, and where the second elasticity component includes an outer surface defining the furthest point on the second elasticity component from the body along the horizontal direction H. The example structure includes a first clamp component connected to the body between the first and the second end. The structure includes a second clamp component connected to the body between the first end and the second end. In an example embodiment, the first clamp component and the second clamp component are configured to secure the magnetic sensor. In an example embodiment, the structure is compressible in response to an application of force applied to the outer surface of the first elasticity component and the outer surface of the second elasticity component.

In an example embodiment, the two or more clamp components are configured to secure a hall component.

In an example embodiment, the structure is made at least partially of metal.

In an example embodiments, the metal includes copper.

In an example embodiment, the structure is configured to ground the open loop magnetic core when compressed between the first face of the open loop magnetic core and the second face of the open loop magnetic core.

In an example embodiment, at least one of the first elasticity component and the second elasticity component isa curved shape.

In an example embodiment, at least one of the first elasticity component and the second elasticity component includes a first section proximal to the body and a second section distal to the body, where the first section is wider than the second section.

In an example embodiment, the body defines an aperture, where the body is configured to be coupled to a housing component that extends through the aperture.

In an example embodiment, at least one of the first clamp component or the second clamp component includes a first section proximal to the body and a second section distal to the body, where the first section has a uniform width, and where the second section has a variable width.

In an example embodiment, wherein the first clamp component and the second clamp component are configured to secure the magnetic sensor in an instance in which the structure is compressed.

In an example embodiment, an assembly is provided. The example assembly includes an upper housing component. The example assembly includes a lower housing component. The example assembly includes an open loop magnetic core. The example assembly includes a magnetic sensor. The example assembly includes a structure. The structure of the example assembly includes a body extending in a horizontal direction H and a transverse direction T orthogonal to horizontal direction H, where the body includes a first end and a second end spaced along horizontal direction H. The structure of the example assembly includes a first elasticity component connected to the first end, where the first elasticity component extends in a direction away from the body, and where the first elasticity component includes an outer surface defining the furthest point on the first elasticity component from the body along the horizontal direction H. The structure of the example assembly includes a second elasticity component connected to the second end, where the second elasticity component extends in a direction away from the body, and where the second elasticity component includes an outer surface defining the furthest point on the second elasticity component from the body along the horizontal direction H. The structure of the example assembly includes a first clamp component connected to the body between the first end and the second end. The structure includes a second clamp component connected to the body between the first end and the second end. In an example embodiment, the first clamp component and the second clamp component are configured to secure the magnetic sensor. In an example embodiment, a distance D1 between the outer surface of the first elasticity component and the outer surface of the second elasticity component is longer than a distance D2 defining the length between a first face of the open loop magnetic core and a second face of the open loop magnetic core. In an example embodiment, the structure is configured to be compressed between the first face of the open loop magnetic core and the second face of the open loop magnetic core by contact with the outer surface of the first elasticity component and the outer surface of the second elasticity component.

In an example embodiment, the magnetic sensor includes a hall component.

In an example embodiment, the structure is made at least partially of metal.

In an example embodiment, the metal includes copper.

In an example embodiment, the structure is configured to ground the open loop magnetic core when compressed between the first face of the open loop magnetic core and the second face of the open loop magnetic core.

In an example embodiment, at least one of the first elasticity component and the second elasticity component is a curved shape.

In an example embodiment, at least one of the first elasticity component and the second elasticity component includes a first section proximal to the body and a second section distal to the body, where the first section is wider than the second section.

In an example embodiment, the body defines an aperture, where the upper housing component configured to be couple to the body and extend through the aperture.

In an example embodiment, at least one of the two or more clamp components includes a first section proximal to the body and a second section distal to the body, where the first section has a uniform width, and where the second section has a variable width.

In an example embodiment, the distance between the first face of the open loop magnetic core and the magnetic sensor describes a distance D3, where the distance D3 is maintained in a circumstance where the open loop magnetic core is displaced.

### BRIEF DESCRIPTION OF THE DRAWINGS

Having thus described certain example embodiments of the present disclosure in general terms above, non-limiting and non-exhaustive embodiments of the subject disclosure are described with reference to the following figures, which are not necessarily drawn to scale and wherein like reference numerals refer to like parts throughout the various views unless otherwise specified. The components illustrated in the figures may or may not be present in certain embodiments described herein. Some embodiments may include fewer (or more) components than those shown in the figures.
FIG. 1 provides a perspective view of a structure, in accordance with an example embodiment.
FIG. 2 provides a perspective view of a structure being compressed between a first face of an open loop magnetic core and a second face of the open loop magnetic core, in accordance with an example embodiment.
FIG. 3 provides a front view of a structure securing a magnetic sensor between a first face of an open loop magnetic core and a second face of the open loop magnetic core, in accordance with an example embodiment.
FIGS. 4A-4B provide front views of a structure securing a magnetic sensor between a first face of an open loop magnetic core and a second face of the open loop magnetic core when the magnetic core shifts positions, in accordance with an example embodiment.
FIG. 5 provides an exploded view of an assembly, in accordance with an example embodiment.
FIG. 6 provides an example installation scenario for an assembly in accordance with an example embodiment.

### DETAILED DESCRIPTION

One or more embodiments are now fully described with reference to the accompanying drawings, wherein like reference numerals are used to refer to like elements throughout and in which some, but not all embodiments of the inventions are shown. In the following description, for purposes of explanation, numerous specific details are set forth in order to provide a thorough understanding of the various embodiments. It is evident, however, that the various embodiments can be practiced without these specific details. It should be understood that some, but not all embodiments are shown and described herein. Indeed, the embodiments may be embodied in many different forms, and accordingly this disclosure should not be construed as limited to the embodiments set forth herein. Rather, these embodiments are provided so that this disclosure will satisfy applicable legal requirements.

As used herein, the term "exemplary" means serving as an example, instance, or illustration. Any aspect or design described herein as "exemplary" is not necessarily to be construed as preferred or advantageous over other aspects or designs. Rather, use of the word exemplary is intended to present concepts in a concrete fashion. In addition, while a particular feature may be disclosed with respect to only one of several implementations, such feature may be combined with one or more other features of the other implementations as may be desired and advantageous for any given or particular application. Furthermore, to the extent that the terms "includes" and "including" and variants thereof are used in either the detailed description or the claims, these terms are intended to be inclusive in a manner similar to the term "comprising."

As used herein, the term "or" is intended to mean an inclusive "or" rather than an exclusive "or." That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. In addition, the articles "a" and "an" as used in this application and the appended claims should generally be construed to mean "one or more" unless specified otherwise or clear from context to be directed to a singular form.

As used herein, the terms "coupled," "fixed," "attached to," and the like refer to both direct coupling, fixing, or attaching, as well as indirect coupling, fixing, or attaching through one or more intermediate components or features, unless otherwise specified herein. As used herein, coupling can be accomplished through welding one component to another component.

As used herein, the term "positioned directly on" refers to a first component being positioned on a second component such that they make contact. Similarly, as used herein, the term "positioned directly between" refers to a first component being positioned between a second component and a third component such that the first component makes contact with both the second component and the third component. In contrast, a first component that is "positioned between" a second component and a third component may or may not have contact with the second component and the third component. Additionally, a first component that is "positioned between" a second component and a third component is positioned such that there may be other intervening components between the second component and the third component other than the first component.

It is desirable, in some examples, for magnetic sensors to be positioned as centrally as possible between two faces of an open loop magnetic core. For example, a current may be running through an open loop magnetic core, and a magnetic sensor that is positioned centrally between two faces of an open loop magnetic core may be able to accurately read the magnetic field caused by the current. In contrast, a sensor positioned closer to one face or the other may not accurately read the magnetic field caused by the current. In addition, it is desirable, in some examples, for the open loop magnetic core to be grounded in order to, for example, improve electromagnetic compatibility or electromagnetic interference performance. Embodiments of the present disclosure include, but are not limited to, a structure that, in some examples, is configured to position a sensor between two faces of an open loop magnetic core. Embodiments of the present disclosure include, but are not limited to, a structure that, in some examples, is configured to maintain positioning between two faces of an open loop magnetic core as the open loop magnetic core shifts positions.

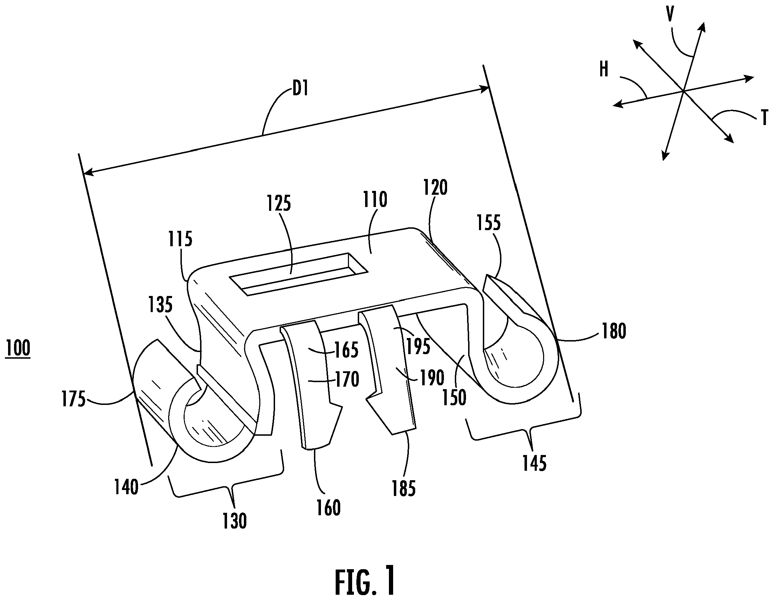

Referring now to Figure 1, an example structure 100 is provided. In one or more embodiments, the structure 100 is configured to secure or otherwise retain a magnetic sensor between two faces of an open loop magnetic core.

In one or more embodiments, structure includes a body 110. In one or more embodiments, the body 110 is a rectangular shaped body. In one or more embodiments, the body 110 is a square shape. In one or more embodiments, a number of shapes may be used depending on, for example, the length between two faces of an open loop magnetic core. In one or more embodiments, the body 110 extends in a horizontal direction H and a transverse direction T orthogonal to horizontal direction H.

In one or more embodiments, the body 110 has a first end 115 and a second end 120 spaced along the horizontal direction H. In one or more embodiments, the distance between first end 115 and second end 120 may be less than the length between the two faces of the open loop magnetic core. In one or more embodiments, the body 110 is made at least partially of metal. For example, the body 110 may include copper. In one or more embodiments, the body 110 is made at least partially of a plastic material. In one or more embodiments, the body 110 is made at least partially of an elastic material. In one or more embodiments, the body 110 is configured to maintain structure when a first elasticity component 130 and/or a second elasticity component 145 are compressed, for example, between two faces of an open loop magnetic core. In one or more embodiments, a distance between first end 115 and second end 120 is between 1 millimeter and 4 millimeters. However, in alternate embodiments, there may be more or less distance between first end 115 and second end 120.

In one or more embodiments, first end 115 is configured to couple body 110 with a first elasticity component 130 extending away from body 110. In one or more embodiments, first end 115 includes a chamfered edge between body 110 and a first elasticity component 130. In one or more embodiments, first end 115 includes an edge between body 110 and first elasticity component 130. In one or more embodiments, first end 115 creates an angle between body 110 and first elasticity component 130. In one or more embodiments, an angle at first end 115 between first elasticity component 130 and body 110 is between 45 degrees and 135 degrees. In alternate embodiments, the angle at first end 115 between first elasticity component 130 and body 110 is less than 45 degrees or greater than 135 degrees.

In one or more embodiments, second end 120 is configured to couple body 110 with a second elasticity component 145 extending away from body 110. In one or more embodiments, second end 120 includes a chamfered edge between body 110 and second elasticity component 145. In one or more embodiments, second end 120 includes an edge between body 110 and second elasticity component 145. In one or more embodiments, second end 120 creates an angle between body 110 and second elasticity component 145. In one or more embodiments, an angle at second end 120 between second elasticity component 145 and body 110 is 90 degrees. In one or more embodiments, the angle at second end 120 between body 110 and second elasticity component 145 is between 45 degrees and 135 degrees. In alternate embodiments, the angle at first end 115 between first elasticity component 130 and body 110 is less than 45 degrees or greater than 135 degrees.

In one or more embodiments, body 110 defines an aperture 125. In one or more embodiments, body 110 defines an aperture 125 that extends through the body 110. In one or more alternative embodiments, body 110 defines an aperture 125 that extends partially through body 110. In one or more embodiments, body 110 defines an aperture 125 with a rectangular shape. In one or more embodiments, body 110 defines an aperture 125 that may be any number of other shapes, including but not limited to circular, square, triangular, pentagonal, hexagonal, and/or the like. In one or more embodiments, the body 110 is configured to be coupled to a housing component that extends through aperture 125.. For example, a portion of a top housing component and/or a bottom housing component may extend through aperture 125 and connect to body 110. In one or more embodiments, a top housing component is coupled to a bottom housing component through aperture 125.

In one or more embodiments, a first elasticity component 130 is provided. In one or more embodiments, first elasticity component 130 possesses a curved shape. In one or more embodiments, first elasticity component includes a first section 135 proximal to body 110 and a second section 140 distal from body 110. In one or more embodiments, first elasticity component 130 extends in a direction away from body 110. For example, in an embodiment where body 110 extends in the horizontal direction H between first end 115 and second end 120 and the transverse direction T orthogonal to horizontal direction H, first section 135 of first elasticity component 130 may be configured to extend in a vertical direction V orthogonal to horizontal direction H. In one or more embodiments, first section 135 may extend, for example within 15 degrees of vertical direction V. In alternative embodiments, first section 135 of first elasticity component 130 may extend away in direction closer to horizontal direction H from body 110, for example within 75 degrees of vertical direction V. In one or more embodiments, second section 140 of first elasticity component 130 may curve from outwardly from body 110 before curving back towards body 110 in at least one of the horizontal direction H and the vertical direction V. In one or more embodiments, the first elasticity component 130 includes an outer surface 175 defining the furthest point on the first elasticity component 130 from body 110 along the horizontal direction H. In one or more embodiments, when first elasticity component 130 is compressed, outer surface 175 moves closer to body 110 in the horizontal direction. For example, outer surface 175 may be compressed between 1% and 10% closer to body 110. In one or more embodiments, outer surface 175 may be compressed less than 1% or more than 10% closer to body 110. In one or more embodiments, deformation of first elasticity component 130 is within an elastic deformation range.

In one or more embodiments, first section 135 of first elasticity component 130 is wider than second section 140 of first elasticity component 130. In one or more embodiments, first elasticity component 130 consists of only one section. In one or more embodiments, first elasticity component 130 consists of two or more sections. In one or more embodiments, first section 135 of first elasticity component 130 is less flexible than second section 140 of first elasticity component 130. In alternative embodiments, first section 135 of first elasticity component 130 is equally or more flexible than second section 140 of first elasticity component 130. In one or more embodiments, first section 135 of first elasticity component 130 is made of a different material than second section 140 of first elasticity component 130. In alternative embodiments first section 135 and second section 140 of first elasticity component 130 are made of the same material.

In one or more embodiments, a curved shape of first elasticity component 130 is configured to be bent when compressed. For example, a first elasticity component 130 may be compressed against a face of an open loop magnetic core.

In one or more embodiments, first elasticity component 130 is made at least partially of an elastic material. For example, first elasticity component 130 may be made at least partially of rubber. In one or more embodiments, first elasticity component 130 is made at least partially of metal. For example, a first elasticity component 130 may be made at least partially of copper. In one or more embodiments where first elasticity component 130 is made at least partially of metal, structure 100 can act as a ground between two faces of an open loop magnetic core. This can lead to improvements in, for example, electromagnetic compatibility and/or electromagnetic interference performance. In one or more alternative embodiments, first elasticity component 130 may be made at least partially of plastic.

In one or more embodiments, a second elasticity component 145 is provided. In one or more embodiments, second elasticity component 145 is a curved shape. In one or more embodiments, first elasticity component includes a first section 150 proximal to body 110 and a second section 155 distal from body 110. In one or more embodiments, second elasticity component 145 extends in a direction away from body 110. For example, in an embodiment where body 110 extends in the horizontal direction H between first end 115 and second end 120 and a transverse direction T orthogonal to horizontal direction H, first section 150 of second elasticity component 145 may be configured to extend in a vertical direction V orthogonal to horizontal direction H. In one or more embodiments, first section 150 may curve and/or extend, for example within 15 degrees of vertical direction V. In alternative embodiments, first section 150 of second elasticity component 145 may curve and/or extend away in direction closer to horizontal direction H from body 110, for example within 75 degrees of vertical direction V. In one or more embodiments, second section 155 of second elasticity component 145 may curve from outwardly from body 110 before curving back towards body 110 in at least one of the horizontal direction H and the vertical direction V. In one or more embodiments, the second elasticity component 145 includes an outer surface 180 defining the furthest point on the second elasticity component 145 from body 110 along the horizontal direction H. In one or more embodiments, when second elasticity component 145 is compressed, outer surface 180 moves closer to body 110 in the horizontal direction. For example, outer surface 180 may be compressed between 1% and 10% closer to body 110. In one or more embodiments, outer surface 180 may be compressed less than 1% or more than 10% closer to body 110. In one or more embodiments, deformation of second elasticity component 145 is within an elastic deformation range.

In one or more embodiments, first section 150 of second elasticity component 145 is wider than second section 155 of second elasticity component 145. In one or more embodiments, second elasticity component 145 consists of only one section. In one or more embodiments, second elasticity component 145 consists of two or more sections. In one or more embodiments, first section 150 of second elasticity component 145 is less flexible than second section 155 of second elasticity component 145. In alternative embodiments, first section 150 of second elasticity component 145 is equally or more flexible than second section 155 of second elasticity component 145. In one or more embodiments, first section 150 of second elasticity component 145 is made of a different material than second section 155 of first elasticity component 150. In alternative embodiments first section 150 and second section 155 of second elasticity component 145 are made of the same material.

In one or more embodiments, a curved shape of second elasticity component 145 is configured to be bent when compressed. For example, a second elasticity component 145 may be compressed against a face of an open loop magnetic core.

In one or more embodiments, second elasticity component 145 is made at least partially of an elastic material. For example, second elasticity component 145 may be made at least partially of rubber. In one or more embodiments, second elasticity component 145 is made at least partially of metal. For example, a second elasticity component 145 may be made at least partially of copper. In one or more embodiments where first elasticity component 130 is made at least partially of metal, structure 100 can act as a ground between two faces of an open loop magnetic core. This can lead to improvements in, for example, electromagnetic compatibility and/or electromagnetic interference. In one or more alternative embodiments, second elasticity component 145 may be made at least partially of plastic.

In one or more embodiments, a distance D1 is defined between the outer surface 175 of first elasticity component 130 and the outer surface 180 of second elasticity component 145. In one or more embodiments, distance D1 is between 3 millimeters and 10 millimeters. In alternative embodiments, distance D1 may be less than 3 millimeters or greater than 10 millimeters. In one or more embodiments, structure 100 is configured to be compressed within two faces that are defined by an open loop magnetic core. In one or more embodiments, the structure 100 is compressed by the faces of the open loop magnetic core when the distance between the faces defines a distance D2 that is less than the distance D1. In one or more embodiments, the first elasticity component and the second elasticity component are compressed so that the structure fits into the space between the faces spanning the distance D2. In one or more embodiments where structure 100 is compressed between two faces, for example of an open loop magnetic core, the distance D1 between outer surface 175 and outer surface 180 may decrease. For example, the distance D1 may decrease by between 1% and 10%. In one or more embodiments, the distance D1 may decrease by less than 1% or more than 10%. In one or more embodiments, distance D1 may decrease by an amount within an elastic deformation range for structure 100.

In one or more embodiments, structure 100 includes a first clamp component 160. In one or more embodiments, the first clamp component 160 is connected to the body between first end 115 and second end 120. In one or more embodiments, the first clamp component 160 is configured to secure a sensor. In one or more embodiments, the fist clamp component 160 may secure the sensor against a second clamp component 185. For example, the first clamp component 160 may be configured to secure a magnetic sensor. In one or more embodiments, the first clamp component 160 may be configured to secure a current sensor. In one or more embodiments, first clamp component 160 may be configured to secure a circuit board. In one or more embodiments, the circuit board may include a hall component. In one or more embodiments, the circuit board may include an output pin. In one or more embodiments, the first clamp component 160 may be configured to secure an anisotropic magnetoresistance effect sensor. In one or more embodiments, the first clamp component 160 may be configured to secure a giant magnetoresistance effect sensor. In one or more embodiments, the first clamp component 160 may be configured to secure a tunnel magnetoresistance effect sensor.

In one or more embodiments, first clamp component 160 is made of the same material as body 110. In one or more embodiments, the first clamp component 160 is made at least partially of metal. In one or more embodiments, the first clamp component 160 is made at least partially of copper. In one or more embodiments, the first clamp component 160 is made at least partially of plastic.

In one or more embodiments, first clamp component 160 includes a first section 165 proximate to the body 110 and a second section 170 distal from the body 110. In one or more embodiments, a first section 165 has a uniform width, for example, in the transverse direction T. In one or more embodiments, a second section 170 has a variable width, for example, in the transverse direction T. In one or more embodiments, the first section 165 and second section 170 of the at first clamp component 160 may be made of different materials. In one or more alternative embodiments, the first section 165 and second section 170 may be made of the same material. In one or more embodiments, the first clamp component 160 only has one section. In one or more embodiments, a first clamp component 160 having a single section may have a uniform width. In alternative embodiments, a first clamp component 160 having a single section may have a variable width.

In one or more embodiments, structure 100 includes a second clamp component 185. In one or more embodiments, the second clamp component 185 is connected to the body between first end 115 and second end 120. In one or more embodiments, the second clamp component 185 is configured to secure a sensor. In one or more embodiments, the second clamp component 185 may secure the sensor against a first clamp component 160. For example, the second clamp component 185 may be configured to secure a magnetic sensor. In one or more embodiments, the second clamp component 185 may be configured to secure a current sensor. In one or more embodiments, second clamp component 185 may be configured to secure a circuit board. In one or more embodiments, the circuit board may include a hall component. In one or more embodiments, the circuit board may include an output pin. In one or more embodiments, the second clamp component 185 may be configured to secure an anisotropic magnetoresistance effect sensor. In one or more embodiments, the second clamp component 185 may be configured to secure a giant magnetoresistance effect sensor. In one or more embodiments, the second clamp component 185 may be configured to secure a tunnel magnetoresistance effect sensor.

In one or more embodiments, second clamp component 185 is made of the same material as body 110. In one or more embodiments, the second clamp component 185 is made at least partially of metal. In one or more embodiments, the second clamp component 185 is made at least partially of copper. In one or more embodiments, the second clamp component 185 is made at least partially of plastic.

In one or more embodiments, second clamp component 185 includes a first section 195 proximate to the body 110 and a second section 190 distal from the body 110. In one or more embodiments, a first section 195 has a uniform width, for example, in the transverse direction T. In one or more embodiments, a second section 190 has a variable width, for example, in the transverse direction T. In one or more embodiments, the first section 195 and second section 190 of the at second clamp component 185 may be made of different materials. In one or more alternative embodiments, the first section 195 and second section 190 may be made of the same material. In one or more embodiments, the second clamp component 185 only has one section. In one or more embodiments, a second clamp component 185 having a single section may have a uniform width. In alternative embodiments, a second clamp component 185 having a single section may have a variable width.

In one or more embodiments, the fist clamp component 160 and the second clamp component 185 are configured to secure a sensor by compressing the sensor between the first clamp component and the second clamp component. In one or more embodiments, the sensor is held between first sections 165 and 195 of uniform width and above second sections 170 and 190 of variable width. In one or more embodiments, the first clamp component 160 and the second clamp component 185 are configured to secure a magnetic sensor. In one or more embodiments, the first clamp component 160 and the second clamp component 185 are configured to secure an anisotropic magnetoresistance effect sensor. In one or more embodiments, the first clamp component 160 and the second clamp component 185 are configured to secure a giant magnetoresistance effect sensor. In one or more embodiments, the first clamp component 160 and the second clamp component 185 are configured to secure a tunnel magnetoresistance effect sensor. Although two clamp components are illustrated, less than two or more than two clamp components may be used to secure a sensor in alternative embodiments.

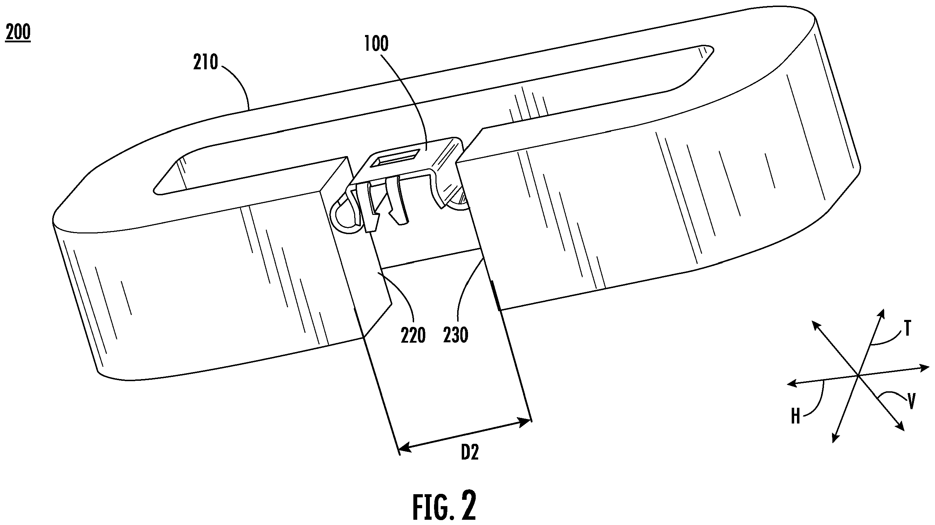

Turning now to Figure 2, a perspective view of structure 100 being compressed in an open loop magnetic core 210 is illustrated. In one or more embodiments, structure 100 is placed between face 220 and face 230 of open loop magnetic core 210. In one or more embodiments, the distance between face 220 and face 230 of open loop magnetic core 210 is defined as D2. In one or more embodiments, distance D1 is longer than distance D2. In one or more embodiments, distance D1 is longer than distance D2 when the structure is not compressed between face 220 and face 230 of open loop magnetic core 210.In one or more embodiments, the distance D1 between outer surfaces 175 and 180 of structure 100 is decreased to the distance D2 when structure 100 is placed between face 220 and face 230. In one or more embodiments, compressive force from face 220 and face 230 compress structure 100 such that it stays still between face 220 and face 230. In one or more embodiments, structure 100 acts as a ground to open loop magnetic core 210, such that electromagnetic compatibility and/or electromagnetic interference performance is improved.

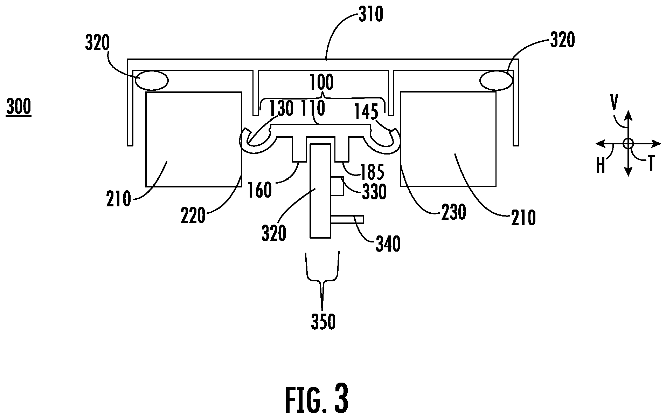

Turning now to Figure 3, a front view of an assembly 300 is provided including a structure 100 secured between a first face 220 and a second face 230 of open loop magnetic core 210. In one or more embodiments, assembly 300 further includes a housing component 310. In one or more embodiments, housing component 310 is configured to cover the open loop magnetic core 210. In one or more embodiments, housing component 310 may be part of, for example, an electrical vehicle. In one or more embodiments, housing 310 is made of a plastic material. In alternative embodiments, housing 310 may be made from a variety of other materials. In one or more embodiments, housing component 310 is electrically insulated from a current running through open loop magnetic core 210.

In one or more embodiments, housing 310 is secured to open loop magnetic core 210. In one or more embodiments, housing 310 is secured to open loop magnetic core 210 using glue 320. In one or more embodiments, housing 310 may be secured to open loop magnetic core 210 using other means. For example, housing 310 may be secured to open loop magnetic core 210 using an adhesive, compression, or other means of attachment.

In one or more embodiments, the clamp components 160 of structure 400 are securing a sensor 350. In one or more embodiments, sensor 350. In one or more embodiments, sensor 350 is an electrical current sensor. In one or more embodiments, sensor 350 is a magnetic sensor. In one or more embodiments, sensor 330 includes circuit board 320, output pin 330, and/or hall component 340. In one or more embodiment, hall component 340 detects the strength of the magnetic field produced by open loop magnetic core 210 when a current is running through open loop magnetic core 210. In one or more embodiments, hall component 340 is most accurate when it is placed in the center between first face 220 and second face 230. In one or more embodiments, output pin 330 indicates the strength of the magnetic field by producing a voltage. In one or more embodiments, sensor 350 may determine an anisotropic magnetoresistance effect. In one or more embodiments, sensor 350 may determine a giant magnetoresistance effect. In one or more embodiments, sensor 350 may determine a tunnel magnetoresistance effect.

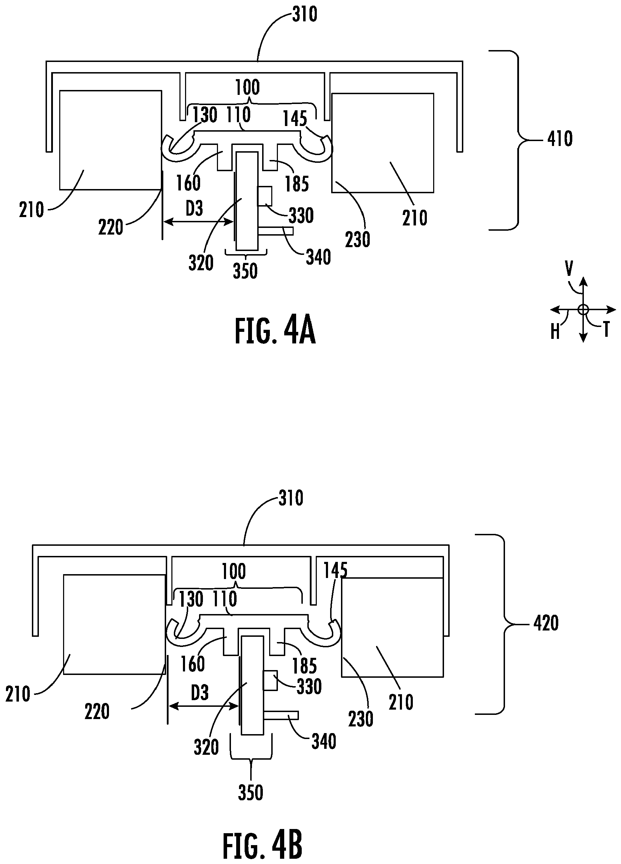

Turning now to Figures 4A, an illustration 410 is provided where the open loop magnetic core 210 is shifted to the left within housing 310. This may happen for a number of example reasons such as glue 320 wearing off. In one or more embodiments, a distance D3 defines the distance between the circuit board 320 of sensor 350 and the first face 220 of the open loop magnetic core 210. In one or more embodiments, structure 100 and therefore sensor 350 move with the open loop magnetic core 210 so that the distance D3 is maintained.
Turning now to Figure 4B, an illustration 420 is provided where the open loop magnetic core is shifted to the right within housing 310. In one or more embodiments, the distance D3 remains the same as shown in Figure 4A. In one or more embodiments, the clamp components 160 continue to secure the sensor 350 at the same distance from the first face 220 and the second face 230. This may provide example technical advantages by allowing sensor 350 to give consistent readings of magnetic field strength produced by open loop magnetic core 210. In one or more embodiments, readings from hall component 340 remain accurate when sensor component 350 is positioned centrally between first face 220 and second face 230 of open loop magnetic core 210.

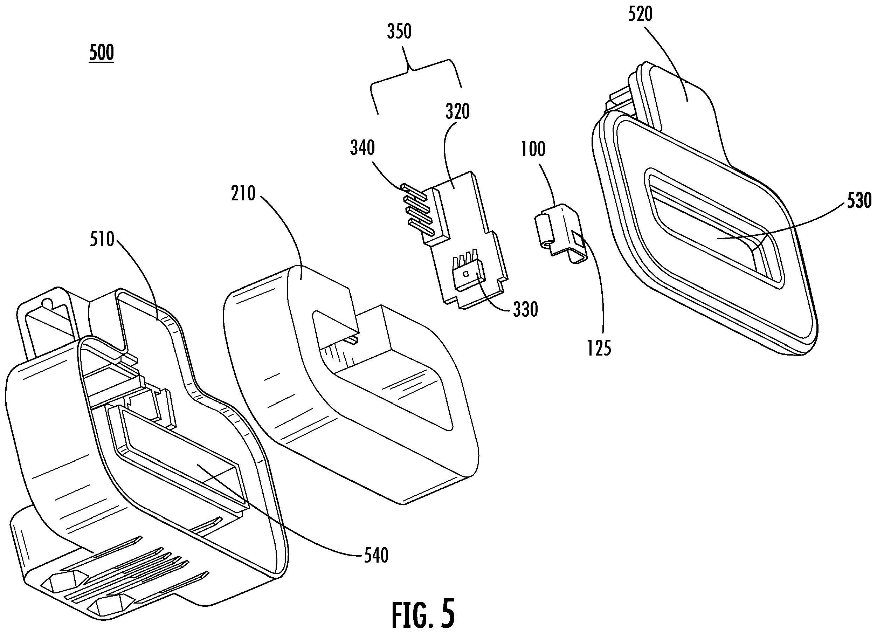

Turning now to Figure 5, an exploded view of an assembly 500 is provided. In one or more embodiments, the assembly includes structure 100, sensor 350, open loop magnetic core 210, upper housing component 520, and lower housing component 510. In one or more embodiments, assembly 500 may be used in a variety of applications, such as in an electric vehicle. In other embodiments, assembly 500 may be used to read a level of current in any passing through apertures 530-540 in a variety of circumstances.

In one or more embodiments, structure 100 is configured to secure sensor 350 within open loop magnetic core 210. In one or more embodiments, open loop magnetic core 210 is covered by an upper housing component 520. In one or more embodiments, upper housing component 520 is further configured to extend through aperture 125 and couple with body 110 of structure 100. In one or more embodiments, upper housing component 520 is made of a plastic material. In one or more embodiments, upper housing component 520 may be made of a different material. In one or more embodiments, aperture 530 of upper housing component 520 may have a current run through it. In one or more embodiments, the current will cause open loop magnetic core 210 to generate a magnetic field. In one or more embodiments, a strength of the magnetic field is detected by sensor 350, which is secured by structure 100. In one or more embodiments where structure 100 is made at least partially of metal, open loop magnetic core 210 is grounded, improving electromagnetic compatibility and/or electromagnetic interference performance. In one or more embodiments, upper housing component 520 is configured to be coupled with lower housing component 520.

In one or more embodiments, lower housing component 510 is configured to cover open loop magnetic core 210. In one or more embodiments, lower housing component 510 is configured to be coupled with upper housing component 520. In one or more embodiments, lower housing component 510 is configured to extend through aperture 125 and couple with body 110 of structure 100. In one or more embodiments, lower housing component 510 is configured to be coupled with upper housing component 520 through aperture 125. In one or more embodiments, a current may run through aperture 540. In one or more embodiments, surrounding the assembly 500 with lower housing component 510 and upper housing component 520 gives structural integrity to assembly 500 and allows a current to run through apertures 530 and 540. In one or more embodiments, in a case where open loop magnetic core 210 moves relative to upper housing component 520 and/or lower housing component 510, structure 100 moves sensor 350 so that the relative distance between sensor 350 and the faces of open loop magnetic core 210 remain constant.

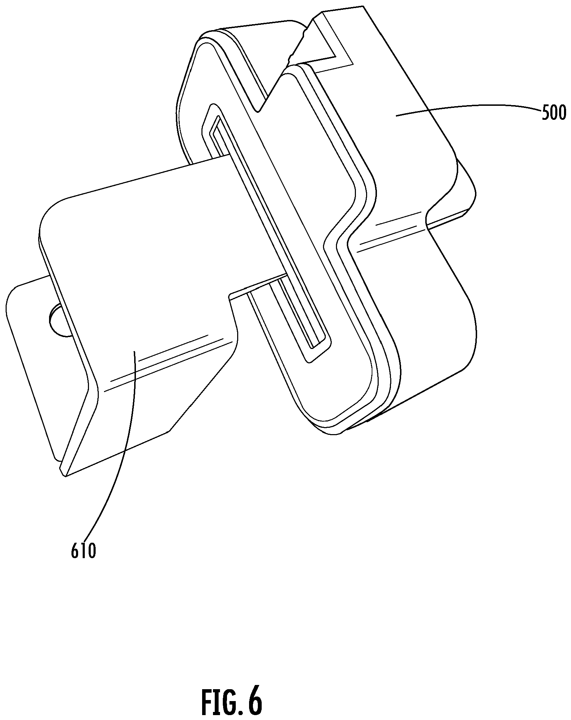

Turning now to Figure 6, an example installation scenario for assembly 500 is provided in accordance with an example embodiment. In one or more embodiments, the lower housing component 510 and the upper housing component 520 are coupled together and surround structure 100, sensor 350, and open loop magnetic core 210. In one or more embodiments, a busbar 610 runs through an aperture formed by apertures 530 and 540. In one or more embodiments, busbar 610 has a current running through it. In one or more embodiments, a magnetic field is created by open loop magnetic core 210 when the current runs through busbar 610. In one or more embodiments, a sensor 350 is able to accurately read the magnetic field when secured by structure 100.

### Conclusion

The above descriptions of various embodiments of the subject disclosure and corresponding figures and what is described in the Abstract, are described herein for illustrative purposes, and are not intended to be exhaustive or to limit the disclosed embodiments to the precise forms disclosed. It is to be understood that one of ordinary skill in the art may recognize that other embodiments having modifications, permutations, combinations, and additions can be implemented for performing the same, similar, alternative, or substitute functions of the disclosed subject matter, and are therefore considered within the scope of this disclosure. Therefore, the disclosed subject matter should not be limited to any single embodiment described herein, but rather should be construed in breadth and scope in accordance with the appended claims below. Moreover, although the foregoing descriptions and the associated drawings describe example embodiments in the context of certain example combinations of elements and/or functions, it should be appreciated that different combinations of elements and/or functions may be provided by alternative embodiments without departing from the scope of the appended claims. In this regard, for example, different combinations of elements and/or functions than those explicitly described above are also contemplated as may be set forth in some of the appended claims. Although specific terms are employed herein, they are used in a generic and descriptive sense only and not for purposes of limitation.

## Claims

1. A structure for reducing displacement of a magnetic sensor in an open loop magnetic core, comprising:
a body extending in a horizontal direction H and a transverse direction T orthogonal to horizontal direction H, wherein the body comprises a first end and a second end spaced along the horizontal direction H;
a first elasticity component connected to the first end, wherein the first elasticity component extends in a direction away from the body, and wherein the first elasticity component comprises an outer surface defining the furthest point on the first elasticity component from the body along the horizontal direction H;
a second elasticity component connected to the second end, wherein the second elasticity component extends in a direction away from the body, and wherein the second elasticity component comprises an outer surface defining the furthest point on the second elasticity component from the body along the horizontal direction H;
a first clamp component connected to the body between the first end and the second end; and
a second clamp component connected to the body between the first end and the second end,
wherein the first clamp component and the second clamp component are configured to secure the magnetic sensor, and
wherein the structure is compressible in response to an application of force applied to the outer surface of the first elasticity component and the outer surface of the second elasticity component.

2. The structure of claim 1, wherein the two or more clamp components are configured to secure a hall component.

3. The structure of claim 1, wherein the structure is made at least partially of metal.

4. The structure of claim 3, wherein the metal comprises copper.

5. The structure of claim 3, wherein the structure is configured to ground the open loop magnetic core when compressed between the first face of the open loop magnetic core and the second face of the open loop magnetic core.

6. The structure of claim 1, wherein at least one of the first elasticity component and the second elasticity component is a curved shape.

7. The structure of claim 6, wherein at least one of the first elasticity component and the second elasticity component comprises a first section proximal to the body and a second section distal to the body, wherein the first section is wider than the second section.

8. The structure of claim 1, wherein the body defines an aperture, wherein the body is configured to be coupled to a housing component that extends through the aperture.

9. The structure of claim 1, wherein at least one of the first clamp component or the second clamp component comprises a first section proximal to the body and a second section distal to the body, wherein the first section has a uniform width, and wherein the second section has a variable width.

10. The structure of claim 1, wherein the first clamp component and the second clamp component are configured to secure the magnetic sensor in an instance in which the structure is compressed.
